(19) Europäisches Patentamt
European Patent Office
Office européen des brevets

(11) **EP 3 785 553 A1**

(12) **EUROPEAN PATENT APPLICATION**

(43) Date of publication:
**03.03.2021 Bulletin 2021/09**

(51) Int Cl.:
***A24F 40/50*** *(2020.01)*

(21) Application number: **19194600.3**

(22) Date of filing: **30.08.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **NERUDIA LIMITED**
**Liverpool Merseyside L24 9HP (GB)**

(72) Inventor: **The designation of the inventor has not yet been filed**

(74) Representative: **Mewburn Ellis LLP**
**Aurora Building**
**Counterslip**
**Bristol BS1 6BX (GB)**

(54) **SMOKING SUBSTITUTE DEVICE AND CONTROL METHOD**

(57)    A method for controlling the power delivered to a heating element of a smoking substitute device includes the steps of: determining a power source voltage of a power source of the smoking substitute device, the power source electrically connected or electrically connectable to the heating element; determining whether the power source voltage falls within a first power source voltage range or a second power source voltage range, wherein all power source voltages in the second power source voltage range are greater than all power source voltages in the first power source voltage range; and varying a duty cycle regime based on a result of the determination.

FIG 2A

**Description**

**TECHNICAL FIELD OF THE INVENTION**

The present invention relates to a method for controlling the amount of power delivered to the heating element of a smoking substitute device, and smoking substitute devices which are configured to perform that method.

**BACKGROUND TO THE INVENTION**

The smoking of tobacco is generally considered to expose a smoker to potentially harmful substances. It is generally thought that a significant amount of the potentially harmful substances are generated through the heat caused by the burning and/or combustion of the tobacco and the constituents of the burnt tobacco in the tobacco smoke itself.

Combustion of organic material such as tobacco is known to produce tar and other potentially harmful by-products. There have been proposed various smoking substitute devices in order to avoid the smoking of tobacco.

Such smoking substitute devices can form part of nicotine replacement therapies aimed at people who wish to stop smoking and overcome a dependence on nicotine.

Smoking substitute devices, which may also be known as electronic nicotine delivery systems, may comprise electronic systems that permit a user to simulate the act of smoking by producing an aerosol, also referred to as a "vapour", which is drawn into the lungs through the mouth (inhaled) and then exhaled. The inhaled aerosol typically bears nicotine and/or flavourings without, or with fewer of, the odour and health risks associated with traditional smoking.

In general, smoking substitute devices are intended to provide a substitute for the rituals of smoking, whilst providing the user with a similar experience and satisfaction to those experienced with traditional smoking and tobacco products.

The popularity and use of smoking substitute devices has grown rapidly in the past few years. Although originally marketed as an aid to assist habitual smokers wishing to quit tobacco smoking, consumers are increasingly viewing smoking substitute devices as desirable lifestyle accessories. Some smoking substitute devices are designed to resemble a traditional cigarette and are cylindrical in form with a mouthpiece at one end. Other smoking substitute devices do not generally resemble a cigarette (for example, the smoking substitute device may have a generally box-like form).

There are a number of different categories of smoking substitute devices, each utilising a different smoking substitute approach. A smoking substitute approach corresponds to the manner in which the substitute system operates for a user.

One approach for a smoking substitute device is the so-called "vaping" approach, in which a vaporisable liquid, typically referred to (and referred to herein) as "e-liquid", is heated by a heater to produce an aerosol vapour which is inhaled by a user. An e-liquid typically includes a base liquid as well as nicotine and/or flavourings. The resulting vapour therefore typically contains nicotine and/or flavourings. The base liquid may include propylene glycol and/or vegetable glycerine.

A typical vaping smoking substitute device includes a mouthpiece, a power source (typically a battery), a tank or liquid reservoir for containing e-liquid, as well as a heater. In use, electrical energy is supplied from the power source to the heater, which heats the e-liquid to produce an aerosol (or "vapour") which is inhaled by a user through the mouthpiece.

Vaping smoking substitute devices can be configured in a variety of ways. For example, there are "closed system" vaping smoking substitute devices which typically have a heater and a sealed tank which is pre-filled with e-liquid and is not intended to be refilled by an end user. One subset of closed system vaping smoking substitute devices include a main body which includes the power source, wherein the main body is configured to be physically and electrically coupled to a consumable including the tank and the heater. In this way, when the tank of a consumable has been emptied, the main body can be reused by connecting it to a new consumable. Another subset of closed system vaping smoking substitute devices are completely disposable, and intended for one-use only.

There are also "open system" vaping smoking substitute devices which typically have a tank that is configured to be refilled by a user, so the device can be used multiple times.

An example vaping smoking substitute device is the myblu™ e-cigarette. The myblu™ e cigarette is a closed system device which includes a main body and a consumable. The main body and consumable are physically and electrically coupled together by pushing the consumable into the main body. The main body includes a rechargeable battery. The consumable includes a mouthpiece, a sealed tank which contains e-liquid, as well as a vaporiser, which for this device is a heating filament coiled around a portion of a wick which is partially immersed in the e-liquid. The device is activated when a microprocessor on board the main body detects a user inhaling through the mouthpiece. When the device is activated, electrical energy is supplied from the power source to the vaporiser, which heats e-liquid from the tank to produce a vapour which is inhaled by a user through the mouthpiece.

Another example vaping smoking substitute device is the blu PRO™ e-cigarette. The blu PRO™ e cigarette is an open system device which includes a main body, a (refillable) tank, and a mouthpiece. The main body and tank are physically and electrically coupled together by screwing one to the other. The mouthpiece and refillable tank are physically coupled together by screwing one into the other, and detaching the mouthpiece from the refillable tank allows the tank to be refilled with e-liquid. The device is activated by a button on the main body. When the device is activated, electrical energy is supplied from the power source to a vaporiser, which heats e-liquid from the tank to produce a vapour which is inhaled by a user through the mouthpiece.

An alternative to the "vaping" approach is the so-called Heated Tobacco ("HT") approach in which tobacco (rather than an e-liquid) is heated or warmed to release vapour. HT is also known as "heat not burn" ("HNB"). The tobacco may be leaf tobacco or reconstituted tobacco. In the HT approach the intention is that the tobacco is heated but not burned, i.e. the tobacco does not undergo combustion.

The heating, as opposed to burning, of the tobacco material is believed to cause fewer, or smaller quantities, of the more harmful compounds ordinarily produced during smoking. Consequently, the HT approach may reduce the odour and/or health risks that can arise through the burning, combustion and pyrolytic degradation of tobacco.

A typical HT smoking substitute system may include a device and a consumable. The consumable may include the tobacco material. The device and consumable may be configured to be physically coupled together. In use, heat may be imparted to the tobacco material by a heating element of the device, wherein airflow through the tobacco material causes components in the tobacco material to be released as vapour. A vapour may also be formed from a carrier in the tobacco material (this carrier may for example include propylene glycol and/or vegetable glycerine) and additionally volatile compounds released from the tobacco. The released vapour may be entrained in the airflow drawn through the tobacco. As the vapour passes through the consumable (entrained in the airflow) from the location of vaporization to an outlet of the consumable (e.g. a mouthpiece), the vapour cools and condenses to form an aerosol for inhalation by the user. The aerosol may contain nicotine and/or flavour compounds.

## SUMMARY OF THE INVENTION

In both the vaping and HNB cases described in the previous section, it is desirable to control the amount of power which is supplied to the heating element of the smoking substitute device. If too much power is supplied to a vaping device, there is a risk that the wick may burn, or that components of the e-liquid may burn, rather than evaporate, giving rise to undesirable chemicals in the vapour which is to be inhaled by the user. Along the same lines, if too much power is supplied to the heating element of a HNB device, the consumable may burn, rather than heat, thus defying the point of the device. In order to address this, the present invention provides a method of controlling the amount of power which is delivered to the heating element of a smoking substitute device. Broadly speaking, the present invention achieves this control by varying the duty cycle of the heating element based on a power source voltage, and accordingly the root mean squared voltage (RMS) supplied to the heating element. Specifically, a first aspect of the present invention provides a method for controlling the power delivered to a heating element of a smoking substitute device, the method including the steps of: determining a power source voltage of a power source of the smoking substitute device, the power source electrically connected or electrically connectable to the heating element; determining whether the power source voltage falls within a first power source voltage range or a second power source voltage range, wherein all power source voltages in the second power source voltage range are greater than all power source voltages in the first power source voltage range; and varying a duty cycle regime based on a result of the determination.

The power source may include a battery (e.g. a rechargeable battery). The heating element of the smoking substitute device may be connected directly to the power source. Here, the term "directly" should be understood to mean that there is a direct (i.e. uninterrupted) connection between the power source and the heating element. There may also be some protection circuitry, but in general, there will be no other intermediate components connected between the heating element and the power source. The power source voltage may be measured by connecting a voltmeter such as an ADC (analogue-digital converter) across the power source.

The electrical connection between the heating element and the power source may be controlled or controllable by an electronic switch. The electronic switch may be in the form of a transistor, such as a field-effect transistor (FET), which operates by controlling the conductivity between source and train terminals by applying a voltage over a gate. Specifically, the electronic switch may be in the form of a metal-oxide semiconductor field-effect transistor, or MOSFET. Specifically, in some embodiments of the present invention, the voltage to the gate is varied to switch the MOSFET "on" and "off', controlling the flow of current to the heating element. In some embodiments, the gate of the MOSFET is pulled to the power source voltage by a resistor. In embodiments in which the MOSFET is p-type, in its OFF state, there is no current flow between the source and the drain. The gate is driven low, below the threshold to enable conductivity between the source and the drain, for example by the controller.

Throughout the present application, the term "duty cycle" is used to refer to the proportion of time for which the heating element is ON. For example, when the heating element is permanently on, the duty cycle is 100%, and when the heating element is permanently OFF, the duty cycle is 0%. In this application, duty cycles are defined using percentages, but the skilled person is well-aware that the duty cycle may be defined in other ways. To clarify, when a duty cycle is referred to as "higher" or "lower" than another duty cycle, it means that the percentage by which that duty cycle is defined is higher or lower than the percentage representing the other duty cycle. The step of varying the duty cycle regime based on a result of the determination may be performed using pulse-width modulation, in which the voltage and/or current (and correspondingly, the power) which is delivered to the heating element is rapidly switched on and off at a high frequency.

In embodiments in which the power delivered to the heating element is controlled using an electronic switch such as a transistor, PWM may be performed by varying a voltage across the source and gate terminals of the transistor.

The term "duty cycle regime" refers to a range or set of duty cycles. When it is stated that a given duty cycle regime is "higher" or "lower" than another duty cycle, it means that all (or substantially all, i.e. more than 90% of, more than 95% of or more than 99% of) duty cycles within the duty cycle regime are higher or lower all duty cycles within the other regime.

For a duty cycle of 90%, the heating element is ON 90% of the time, and OFF 10% of the time. During a fixed period t, the energy transferred to the heating element from the power source is proportional to the product of the voltage and the fixed period t. The RMS voltage is the average voltage over the period t. It is the effective voltage which is experienced by the heating element when the device is operated at a given duty cycle. When the duty cycle is reduced below 100%, the RMS voltage is less than the power source voltage.

In preferred embodiments, the first power source voltage range and second power source voltage range are preferably non-overlapping, and cover the full range of power sources at which the power source may be operating. This means that all feasible power source voltages fall within either the first power source voltage range or the second power source voltage range. The method may further include a step of defining a first predetermined power source voltage threshold, which is the power source voltage on the boundary of the first power source voltage range and the second power source voltage range. In such cases, the step of determining whether the power source voltage falls with the first power source voltage range or the second power source voltage range may comprise comparing the determined power source voltage with the first predetermined power source voltage threshold, and the step of varying the duty cycle regime may be based on a result of that comparison.

In the present invention, when the power source voltage is sufficiently high, i.e. exceeds a certain threshold, the device operates at a second duty cycle which is lower than the duty cycle at which the device operates below that threshold. In this way, when the power source voltage is high, the overall power supplied to the heating element is reduced. This ensures that when the power source voltage is high, excessive power (which may cause burning of the consumable) is not supplied to the heating element.

In some embodiments of the present invention, the step of varying a duty cycle may comprise switching between a first duty cycle regime and a second duty cycle regime.

Specifically, the step of varying the duty cycle regime may comprise: if the determined power source voltage is in the first power source voltage range, operating the smoking substitute device at a first duty cycle; and if the determined power source voltage is in the second power source voltage range, operating the smoking substitute device at a second duty cycle, wherein: the first duty cycle is higher than the second duty cycle.

In embodiments of the invention in which a first predetermined power source voltage threshold is defined, the step of varying the duty cycle regime may comprise: if the determined power source voltage is greater than or equal to the predetermined threshold voltage, operating the smoking substitute device at a first duty cycle; and if the determined power source voltage is less than the predetermined threshold voltage, operating the smoking substitute device at a second duty cycle, wherein: the first duty cycle is higher than the second duty cycle. Alternatively, the step of varying a duty cycle may comprise: if the determined power source voltage is greater than the predetermined threshold voltage, operating the smoking substitute device at a first duty cycle; and if the determined power source voltage is less than or equal to the predetermined threshold voltage, operating the smoking substitute device at a second duty cycle, wherein: the first duty cycle is higher than the second duty cycle. Throughout this application, for conciseness, it should be understood that any determination of "greater than or equal to" or "less than" may be interchanged with a determination of "greater than" or "less than or equal to", since this is effectively just a change in the threshold of comparison.

In embodiments of the invention such as those set out in the previous paragraph, the first duty cycle regime and second duty cycle regime may respectively be a first duty cycle and a second duty cycle, wherein the first duty cycle is higher than the second duty cycle. However, alternatively, one or both of the first duty cycle regime and the second duty cycle regime may be a variable duty cycle. For example, the first duty cycle regime and/or the second duty cycle regime may be a duty cycle which varies as a function of some parameter. This parameter may be the determined power source voltage, the current in the heating element, the heater coil resistance, or temperature. The function may be for example:

$$Duty\ cycle = \left(\frac{V_{reference}}{V_{measured}}\right)^2$$

In which $V_{measured}$ is the measured power source voltage, and $V_{reference}$ is some reference voltage, which may be 4 volts. Such a function may apply only for $V_{measured} > V_{reference}$.

When the power source voltage is low, i.e. in the first power source voltage, or below the first predetermined power source voltage threshold, there is a risk that insufficient power will be supplied to the heating element, and therefore that the heating element will be unable to sufficiently heat the consumable to generate the desired vapours. In order to ensure that, below a certain level, maximum power is supplied to the heating element, it is preferred that the first duty cycle regime is a first duty cycle of at least 90%, and more preferably at least 95%, more preferably still at least 99%, and most preferably 100%. In other words, when the power source voltage falls below a certain value, the heating element is permanently on, in order to ensure sufficient heating of the consumable.

In some embodiments, there are more than two duty cycle regimes. In such cases, method may include the step of determining whether the determined power source voltage falls within the first power source voltage range, the second power source voltage range, or the third power source voltage range, wherein all power source voltages within the third power source voltage range are greater than all power source voltages which fall within the second power source range, and the step of varying a duty cycle regime may comprise: if the determined power source voltage falls within the first power source voltage range, operating the smoking substitute device in a first duty cycle regime; if the determined power source voltage falls within the second power source voltage range, operating the smoking substitute device in a second duty cycle regime; and if the determined power source voltage falls within the third power source voltage range, operating the smoking substitute device in a third duty cycle regime, wherein the first duty cycle regime is higher than the second duty cycle regime, and the second duty cycle regime is higher than the second duty cycle regime.

In embodiments in which there are more than two power source voltage ranges, a first predetermined power source voltage threshold and a second predetermined power source voltage threshold may be defined, wherein the first predetermined power source voltage threshold is the power source voltage on the boundary of the first power source voltage range and the second power source voltage range, and the second predetermined power source voltage threshold is the power source voltage on the boundary of the second power source voltage range and the third power source voltage range. Then, the step of determining in which power source voltage range falls may include: comparing the determined power source voltage with the first predetermined power source voltage threshold; and comparing the determined power source voltage with the second predetermined power source voltage threshold. The step of varying a duty cycle regime based on the determination may then include: if the determined power source voltage is less than the first predetermined power source voltage threshold, operating the smoking substitute device in the first duty cycle regime; if the determined power source voltage is greater than or equal to the first predetermined power source voltage regime and less than the second predetermined power source voltage threshold, operating the smoking substitute device in the second duty cycle regime; and if the determined power source voltage is greater than or equal to the second predetermined power source voltage threshold, operating the smoking substitute device in the third duty cycle regime.

Methods of the present invention are not restricted to classifying the determined power source voltage into two or three power source voltage ranges. More generally, a plurality of power source voltage ranges may be defined, where all (or substantially all) power source voltages in each successive power source voltage range are greater than all (or substantially all) power source voltages in all previous power source voltage ranges. Each power source voltage range may have a respective associated duty cycle regime, where each successive duty cycle regime is lower than the previous duty cycle. The method may include a step of determining in which power source voltage range the determined power source voltage falls. Then, the step of varying the duty cycle regime may comprise operating the smoking substitute device in the duty cycle regime which is associated with the determined power source voltage range.

The present invention is not restricted to methods. Accordingly, a second aspect of the invention provides a smoking substitute device including: a power source having an associated power source voltage, the power source arranged to deliver power to a heating element; and control circuitry configured to perform the method of the first aspect of the invention, i.e. to: determine the power source voltage; determine whether the determined power source voltage is in a first power source voltage range or a second power source voltage range, wherein all power source voltages in the second power source voltage range are greater than all power source voltages in the first power source voltage range; and vary a duty cycle regime based on a result of the determination. Specifically, in preferred embodiments of the second aspect of the invention, the control circuitry includes: a voltage-measuring device configured to determine the power source voltage; and a controller configured to: determine whether the determined power source voltage is in a first power source voltage range or a second power source voltage range, wherein all power source voltages in the second power source voltage range are greater than all power source voltages in the first power source voltage range; and vary a duty cycle regime based on a result of the determination. The optional features set out above with respect to the first aspect of the invention also apply equally well to the second aspect of the invention. The skilled person is well-aware which optional features of the first aspect of the invention are compatible with the second aspect of the invention, but for completeness we set out some of the more important combinations below.

The power source may include a battery (e.g. a rechargeable battery). The heating element of the smoking substitute device may be connected directly to the power source. There may also be some protection circuitry, but in general, there will be no other intermediate components connected between the heating element and the power source.

The connection between the heating element and the power source may be controlled by an electronic switch. The electronic switch may be in the form of a transistor, such as a field-effect transistor (FET). Specifically, the electronic switch may be in the form of a metal-oxide semiconductor field-effect transistor, or MOSFET.

The step of varying the duty cycle regime based on a result of the determination may be performed using pulse-width modulation, in which the voltage and/or current (and correspondingly, the power) which is delivered to the heating element is rapidly switched on and off at a high frequency.

In preferred embodiments, the first power source voltage range and second power source voltage range are preferably non-overlapping, and cover the full range of power sources at which the power source may be operating. A first predetermined power source voltage threshold may be determined, which is the power source voltage on the boundary of the first power source voltage range and the second power source voltage range. In such cases, the controller may be configured to compare the determined power source voltage with the first predetermined power source voltage threshold, and to vary the duty cycle regime based on a result of that comparison.

In some embodiments of the present invention, the controller may be configured to switch between a first duty cycle regime and a second duty cycle regime. Specifically, if the determined power source voltage is in the first power source voltage range, the controller may be configured to operate the smoking substitute device at a first duty cycle; and if the determined power source voltage is in the second power source voltage range, the controller may be configured to operate the smoking substitute device at a second duty cycle, wherein: the first duty cycle is higher than the second duty cycle.

In embodiments of the invention in which a first predetermined power source voltage threshold is defined, if the determined power source voltage is greater than or equal to the predetermined threshold voltage, the controller may be configured to operate the smoking substitute device at a first duty cycle; and if the determined power source voltage is less than the predetermined threshold voltage, the controller may be configured to operate the smoking substitute device at a second duty cycle, wherein the first duty cycle is higher than the second duty cycle. Alternatively, if the determined power source voltage is greater than the predetermined threshold voltage, the controller may be configured to operate the smoking substitute device at a first duty cycle; and if the determined power source voltage is less than or equal to the predetermined threshold voltage, the controller may be configured to operate the smoking substitute device at a second duty cycle, wherein: the first duty cycle is higher than the second duty cycle.

In embodiments of the invention such as those set out in the previous paragraph, the first duty cycle regime and second duty cycle regime may respectively be a first duty cycle and a second duty cycle, wherein the first duty cycle is higher than the second duty cycle. However, alternatively, one or both of the first duty cycle regime and the second duty cycle regime may be a variable duty cycle. For example, the first duty cycle regime and/or the second duty cycle regime may be a duty cycle which varies as a function of some parameter. This parameter may be the determined power source voltage, the current in the heating element, the heater coil resistance, or temperature. The function may be for example:

$$Duty\ cycle = \left(\frac{V_{reference}}{V_{measured}}\right)^2$$

In which $V_{measured}$ is the measured power source voltage, and $V_{reference}$ is some reference voltage, which may be 4 volts. Such a function may apply only for $V_{measured} > V_{reference}$.

In order to ensure that, below a certain level, maximum power is supplied to the heating element, it is preferred that the first duty cycle regime is a first duty cycle of at least 90%, and more preferably at least 95%, more preferably still at least 99%, and most preferably 100%.

In some embodiments, there are more than two duty cycle regimes. In such cases, the controller may be configured to determine whether the determined power source voltage falls within the first power source voltage range, the second power source voltage range, or the third power source voltage range, wherein all power source voltages within the third power source voltage range are greater than all power source voltages which fall within the second power source range. If the determined power source voltage falls within the first power source voltage range, the controller may be configured to operate the smoking substitute device in a first duty cycle regime; if the determined power source voltage falls within the second power source voltage range, the controller may be configured to operate the smoking substitute device in a second duty cycle regime; and if the determined power source voltage falls within the third power source voltage range, the controller may be configured to operate the smoking substitute device in a third duty cycle regime, wherein the first duty cycle regime is higher than the second duty cycle regime, and the second duty cycle regime is higher than the second duty cycle regime.

In embodiments in which there are more than two power source voltage ranges, a first predetermined power source voltage threshold and a second predetermined power source voltage threshold may be defined, wherein the first predetermined power source voltage threshold is the power source voltage on the boundary of the first power source voltage range and the second power source voltage range, and the second predetermined power source voltage threshold is the power source voltage on the boundary of the second power source voltage range and the third power source voltage range. Then, the controller may be configured to compare the determined power source voltage with the first predetermined power source voltage threshold; and the controller may be configured to compare the determined power source voltage with the second predetermined power source voltage threshold. Then, if the determined power source voltage is less than the first predetermined power source voltage threshold, the controller may be configured to operate the smoking substitute device in the first duty cycle regime; if the determined power source voltage is greater than or equal to the first predetermined power source voltage regime and less than the second predetermined power source voltage threshold, the controller may be configured to operate the smoking substitute device in the second duty cycle regime; and if the determined power source voltage is greater than or equal to the second predetermined power source voltage threshold, the controller may be configured to operate the smoking substitute device in the third duty cycle regime.

Smoking substitute devices according to the second aspect of the present invention are not restricted to classifying the determined power source voltage into two or three power source voltage ranges. More generally, a plurality of power source voltage ranges may be defined, where all (or substantially all) power source voltages in each successive power source voltage range are greater than all (or substantially all) power source voltages in all previous power source voltage ranges. Each power source voltage range may have a respective associated duty cycle regime, where each successive duty cycle regime is lower than the previous duty cycle. The controller may be configured to determine in which power source voltage range the determined power source voltage falls. Then, the controller may be configured to operate the smoking substitute device in the duty cycle regime which is associated with the determined power source voltage range.

The smoking substitute device may comprise a passage for fluid flow therethrough. The passage may extend through (at least a portion of) the smoking substitute device, between openings that may define an inlet and an outlet of the passage. The outlet may be at a mouthpiece of the smoking substitute device. In this respect, a user may draw fluid (e.g. air) into and through the passage by inhaling at the outlet (i.e. using the mouthpiece).

The device may comprise a tank (reservoir) for containing a vaporisable liquid (e.g. an e-liquid). The e-liquid may, for example, comprise a base liquid and e.g. nicotine. The base liquid may include propylene glycol and/or vegetable glycerine.

The tank may be defined by a tank housing. At least a portion of the tank housing may be translucent. For example, the tank housing may comprise a window to allow a user to visually assess the quantity of e-liquid in the tank. The tank may be referred to as a "clearomizer" if it includes a window, or a "cartomizer" if it does not. The passage may extend longitudinally within the tank and a passage wall may define the inner wall of the tank. In this respect, the tank may surround the passage e.g. the tank may be annular. The passage wall may comprise longitudinal ribs extending along it. These ribs may provide support to the passage wall. The ribs may extend for the full length of the passage wall. The ribs may project (e.g. radially outwardly) into the tank.

The smoking substitute device may comprise a vaporiser. The vaporiser may comprise a wick. The vaporiser may further comprise the heating element. The wick may comprise a porous material. A portion of the wick may be exposed to fluid flow in the passage. The wick may also comprise one or more portions in contact with liquid stored in the reservoir. For example, opposing ends of the wick may protrude into the reservoir and a central portion (between the ends) may extend across the passage so as to be exposed to fluid flow in the passage. Thus, fluid may be drawn (e.g. by capillary action) along the wick, from the reservoir to the exposed portion of the wick.

The heating element may be in the form of a filament wound about the wick (e.g. the filament may extend helically about the wick). The filament may be wound about the exposed portion of the wick. The heating element is electrically connected (or connectable) to a power source. Thus, in operation, the power source may supply electricity to (i.e. apply a voltage across) the heating element so as to heat the heating element. This may cause liquid stored in the wick (i.e. drawn from the tank) to be heated so as to form a vapour and become entrained in fluid flowing through the passage. This vapour may subsequently cool to form an aerosol in the passage.

The smoking substitute device may include a main body which includes the power source and the controller. The main body may be configured for engagement with a consumable. The consumable may comprise components of the system that are disposable, and the main body may comprise non-disposable or non-consumable components (e.g. power supply, controller, sensor, etc.) that facilitate the delivery of aerosol by the consumable. In such an embodiment, the aerosol former (e.g. e-liquid) may be replenished by replacing a used consumable with an unused consumable. The heating element may form part of the main body, or part of a consumable.

In light of this, it should be appreciated that some of the features described herein as being part of the smoking substitute device may alternatively form part of a main body for engagement with the consumable.

The main body and the consumable may be configured to be physically coupled together. For example, the consumable may be at least partially received in a recess of the main body, such that there is snap engagement between the main body and the consumable. Alternatively, the main body and the consumable may be physically coupled together by screwing one onto the other, or through a bayonet fitting.

Thus, the consumable may comprise one or more engagement portions for engaging with a main body. In this way, one end of the consumable (i.e. the inlet end) may be coupled with the main body, while an opposing end (i.e. the outlet end) of the consumable may define a mouthpiece.

The consumable may comprise an electrical interface for interfacing with a corresponding electrical interface of the main body. One or both of the electrical interfaces may include one or more electrical contacts. Thus, when the main body is engaged with the consumable, the electrical interface may be configured to transfer electrical power from the power source to a heater of the consumable. The electrical interface may also be used to identify the consumable from a list of known types. The electrical interface may additionally or alternatively be used to identify when the consumable is connected to the main body. The main body may alternatively or additionally be able to detect information about the consumable via an RFID reader, a barcode or QR code reader. This interface may be able to identify a characteristic (e.g. a type) of the consumable. In this respect, the consumable may include any one or more of an RFID chip, a barcode or QR code, or memory within which is an identifier and which can be interrogated via the interface.

A memory may be provided and may be operatively connected to the controller. The memory may include non-volatile memory. The memory may include instructions which, when implemented, cause the controller to perform certain tasks or steps of a method, such as the method of the first aspect of the invention. The consumable or main body may comprise a wireless interface, which may be configured to communicate wirelessly with another device, for example a mobile device, e.g. via Bluetooth®. To this end, the wireless interface could include a Bluetooth® antenna. Other wireless communication interfaces, e.g. WiFi®, are also possible. The wireless interface may also be configured to communicate wirelessly with a remote server.

An airflow (i.e. puff) sensor may be provided that is configured to detect a puff (i.e. inhalation from a user). The airflow sensor may be operatively connected to the controller so as to be able to provide a signal to the controller that is indicative of a puff state (i.e. puffing or not puffing). The airflow sensor may, for example, be in the form of a pressure sensor or an acoustic sensor. The controller may control power supply to the heater in response to airflow detection by the sensor. The control may be in the form of activation of the heater in response to a detected airflow. The airflow sensor may form part of the consumable or the main body.

In an alternative embodiment the device may be a non-consumable device in which an aerosol former (e.g. e-liquid) of the device may be replenished by refilling the tank of the device (rather than replacing the consumable). In this embodiment, the consumable described above may instead be a non-disposable component that is integral with the main body. Thus the device may comprise the features of the main body described above. In this embodiment, the only consumable portion may be e-liquid contained in the tank of the device. Access to the tank (for re-filling of the e-liquid) may be provided via e.g. an opening to the tank that is sealable with a closure (e.g. a cap).

In a third aspect there is provided a smoking substitute system comprising smoking substitute device according to the second aspect of the invention, and a consumable as described above, the consumable being engageable with the main body such that a heating element of the consumable is connected to the power source of the main body. The consumable may be an e-cigarette consumable. The main body may be as described above with respect to the second aspect of the invention. The main body may, for example, be an e-cigarette device for supplying power to the consumable.

The invention includes the combination of the aspects and preferred features described except where such a combination is clearly impermissible or expressly avoided.

**BRIEF DESCRIPTION OF THE DRAWINGS**

So that the invention may be understood, and so that further aspects and features thereof may be appreciated, embodiments illustrating the principles of the invention will now be discussed in further detail with reference to the accompanying figures, in which:

- Fig. 1A is a front schematic view of a smoking substitute system;

- Fig. 1B is a front schematic view of a main body of the system;

- Fig. 1C is a front schematic view of a consumable of the system;

- Fig. 2A is a schematic of the components of the main body;

- Fig. 2B is a schematic of the components of the consumable;

- Fig. 3 is a section view of the consumable; and

- Fig. 4 is a schematic diagram of the components involved in performing the method of the first aspect of the invention.

## DETAILED DESCRIPTION OF THE EMBODIMENTS

Aspects and embodiments of the present invention will now be discussed with reference to the accompanying figures. Further aspects and embodiments will be apparent to those skilled in the art. All documents mentioned in this text are incorporated herein by reference.

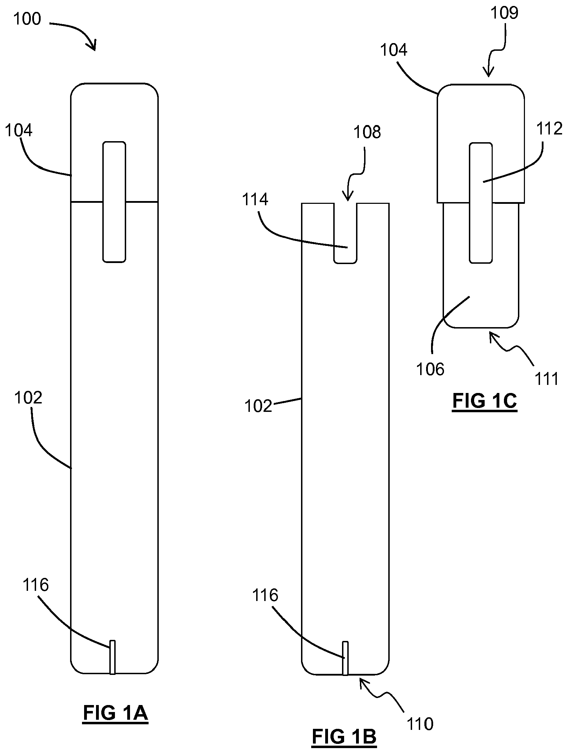

Fig. 1A shows a first embodiment of a smoking substitute system 100. In this example, the smoking substitute system 100 includes a main body 102 and an aerosol delivery device in the form of a consumable 104. The consumable 104 may alternatively be referred to as a "pod", "cartridge" or "cartomizer". It should be appreciated that in other examples (i.e. open systems), the main body may be integral with the consumable such that the aerosol delivery device incorporates the main body. In such systems, a tank of the aerosol delivery device may be accessible for refilling the device.

In this example, the smoking substitute system 100 is a closed system vaping system, wherein the consumable 104 includes a sealed tank 106 and is intended for single-use only. The consumable 104 is removably engageable with the main body 102 (i.e. for removal and replacement). Fig. 1A shows the smoking substitute device 100 with the main body 102 physically coupled to the consumable 104, Fig. 1B shows the main body 102 of the smoking substitute system 100 without the consumable 104, and Fig. 1C shows the consumable 104 of the smoking substitute system 100 without the main body 102.

The main body 102 and the consumable 104 are configured to be physically coupled together by pushing the consumable 104 into a cavity at an upper end 108 of the main body 102, such that there is an interference fit between the main body 102 and the consumable 104. In other examples, the main body 102 and the consumable may be coupled by screwing one onto the other, or through a bayonet fitting.

The consumable 104 includes a mouthpiece (not shown in Fig. 1A, 1B or 1C) at an upper end 109 of the consumable 104, and one or more air inlets (not shown) in fluid communication with the mouthpiece such that air can be drawn into and through the consumable 104 when a user inhales through the mouthpiece. The tank 106 containing e-liquid is located at the lower end 111 of the consumable 104.

The tank 106 includes a window 112, which allows the amount of e-liquid in the tank 106 to be visually assessed. The main body 102 includes a slot 114 so that the window 112 of the consumable 104 can be seen whilst the rest of the tank 106 is obscured from view when the consumable 104 is inserted into the cavity at the upper end 108 of the main body 102.

The lower end 110 of the main body 102 also includes a light 116 (e.g. an LED) located behind a small translucent cover. The light 116 may be configured to illuminate when the smoking substitute system 100 is activated. Whilst not shown, the consumable 104 may identify itself to the main body 102, via an electrical interface, RFID chip, or barcode.

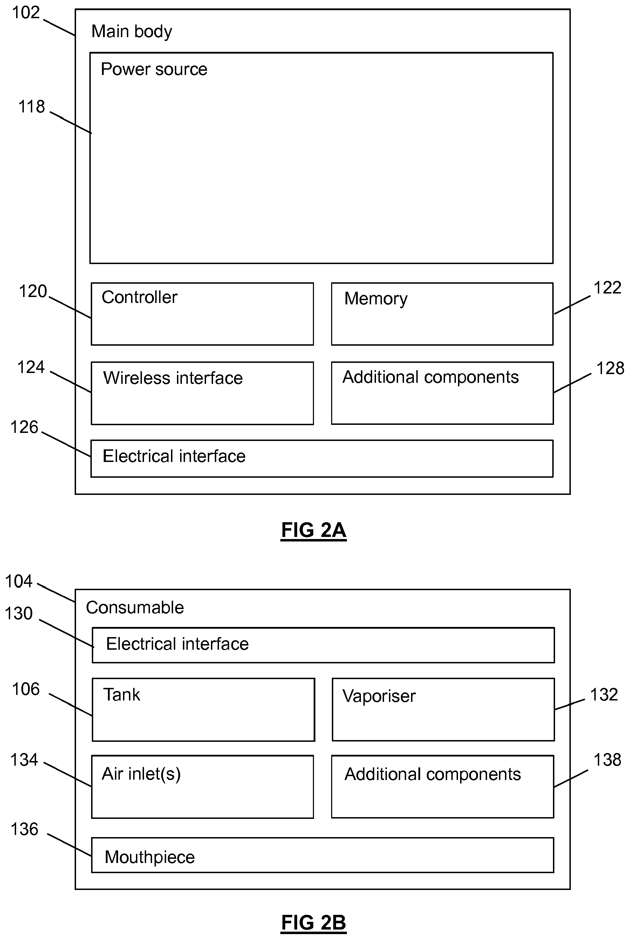

Figs. 2A and 2B are schematic drawings of the main body 102 and consumable 104. As is apparent from Fig. 2A, the main body 102 includes a power source 118, a controller 120, a memory 122, a wireless interface 124, an electrical interface 126, and, optionally, one or more additional components 128.

The power source 118 is preferably a battery, more preferably a rechargeable battery. The controller 120 may include a microprocessor, for example. The memory 122 preferably includes non-volatile memory. The memory may include instructions which, when implemented, cause the controller 120 to perform certain tasks or steps of a method.

The wireless interface 124 is preferably configured to communicate wirelessly with another device, for example a mobile device, e.g. via Bluetooth®. To this end, the wireless interface 124 could include a Bluetooth® antenna. Other wireless communication interfaces, e.g. WiFi®, are also possible. The wireless interface 124 may also be configured to communicate wirelessly with a remote server.

The electrical interface 126 of the main body 102 may include one or more electrical contacts. The electrical interface 126 may be located in a base of the aperture in the upper end 108 of the main body 102. When the main body 102 is physically coupled to the consumable 104, the electrical interface 126 is configured to transfer electrical power from the power source 118 to the consumable 104 (i.e. upon activation of the smoking substitute system 100).

The electrical interface 126 may be configured to receive power from a charging station when the main body 102 is not physically coupled to the consumable 104 and is instead coupled to the charging station. The electrical interface 126 may also be used to identify the consumable 104 from a list of known consumables. For example, the consumable 104 may be a particular flavour and/or have a certain concentration of nicotine (which may be identified by the electrical interface 126). This can be indicated to the controller 120 of the main body 102 when the consumable 104 is connected to the main body 102. Additionally, or alternatively, there may be a separate communication interface provided in the main body 102 and a corresponding communication interface in the consumable 104 such that, when connected, the consumable 104 can identify itself to the main body 102.

The additional components 128 of the main body 102 may comprise the light 116 discussed above.

The additional components 128 of the main body 102 may also comprise a charging port (e.g. USB or micro-USB port) configured to receive power from the charging station (i.e. when the power source 118 is a rechargeable battery). This may be located at the lower end 110 of the main body 102. Alternatively, the electrical interface 126 discussed above may be configured to act as a charging port configured to receive power from the charging station such that a separate charging port is not required.

The additional components 128 of the main body 102 may, if the power source 118 is a rechargeable battery, include a battery charging control circuit, for controlling the charging of the rechargeable battery. However, a battery charging control circuit could equally be located in the charging station (if present).

The additional components 128 of the main body 102 may include a sensor, such as an airflow (i.e. puff) sensor for detecting airflow in the smoking substitute system 100, e.g. caused by a user inhaling through a mouthpiece 136 of the consumable 104. The smoking substitute system 100 may be configured to be activated when airflow is detected by the airflow sensor. This sensor could alternatively be included in the consumable 104. The airflow sensor can be used to determine, for example, how heavily a user draws on the mouthpiece or how many times a user draws on the mouthpiece in a particular time period.

The additional components 128 of the main body 102 may include a user input, e.g. a button. The smoking substitute system 100 may be configured to be activated when a user interacts with the user input (e.g. presses the button). This provides an alternative to the airflow sensor as a mechanism for activating the smoking substitute system 100.

As shown in Fig. 2B, the consumable 104 includes the tank 106, an electrical interface 130, a vaporiser 132, one or more air inlets 134, a mouthpiece 136, and one or more additional components 138.

The electrical interface 130 of the consumable 104 may include one or more electrical contacts. The electrical interface 126 of the main body 102 and an electrical interface 130 of the consumable 104 are configured to contact each other and thereby electrically couple the main body 102 to the consumable 104 when the lower end 111 of the consumable 104 is inserted into the upper end 108 of the main body 102 (as shown in Fig. 1A). In this way, electrical energy (e.g. in the form of an electrical current) is able to be supplied from the power source 118 in the main body 102 to the vaporiser 132 in the consumable 104.

The vaporiser 132 is configured to heat and vaporise e-liquid contained in the tank 106 using electrical energy supplied from the power source 118. As will be described further below, the vaporiser 132 includes a heating filament and a wick. The wick draws e-liquid from the tank 106 and the heating filament heats the e-liquid to vaporise the e-liquid.

The one or more air inlets 134 are preferably configured to allow air to be drawn into the smoking substitute system 100, when a user inhales through the mouthpiece 136. When the consumable 104 is physically coupled to the main body 102, the air inlets 134 receive air, which flows to the air inlets 134 along a gap between the main body 102 and the lower end 111 of the consumable 104.

In operation, a user activates the smoking substitute system 100, e.g. through interaction with a user input forming part of the main body 102 or by inhaling through the mouthpiece 136 as described above. Upon activation, the controller 120 may supply electrical energy from the power source 118 to the vaporiser 132 (via electrical interfaces 126, 130), which may cause the vaporiser 132 to heat e-liquid drawn from the tank 106 to produce a vapour which is inhaled by a user through the mouthpiece 136.

An example of one of the one or more additional components 138 of the consumable 104 is an interface for obtaining an identifier of the consumable 104. As discussed above, this interface may be, for example, an RFID reader, a barcode, a QR code reader, or an electronic interface which is able to identify the consumable. The consumable 104 may, therefore include any one or more of an RFID chip, a barcode or QR code, or memory within which is an identifier and which can be interrogated via the electronic interface in the main body 102.

It should be appreciated that the smoking substitute system 100 shown in figures 1A to 2B is just one exemplary implementation of a smoking substitute system. For example, the system could otherwise be in the form of an entirely disposable (single-use) system or an open system in which the tank is refillable (rather than replaceable).

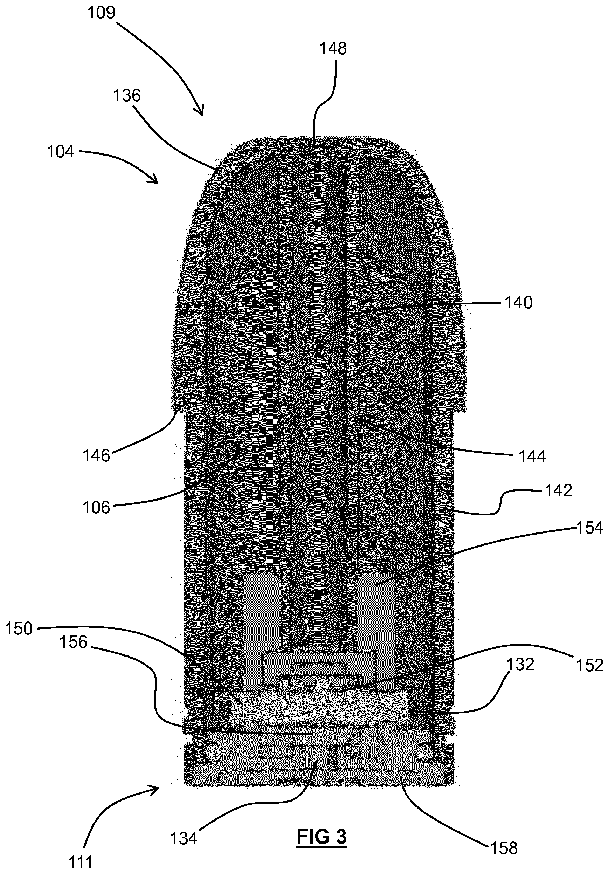

Fig. 3 is a section view of the consumable 104 described above. The consumable 104 comprises a tank 106 for storing e-liquid, a mouthpiece 136 and a passage 140 extending along a longitudinal axis of the consumable 104. In the illustrated embodiment the passage 140 is in the form of a tube having a substantially circular transverse cross-section (i.e. transverse to the longitudinal axis). The tank 106 surrounds the passage 140, such that the passage 140 extends centrally through the tank 106.

A tank housing 142 of the tank 106 defines an outer casing of the consumable 104, whilst a passage wall 144 defines the passage 140. The tank housing 142 extends from the lower end 111 of the consumable 104 to the mouthpiece 136 at the upper end 109 of the consumable 104. At the junction between the mouthpiece 136 and the tank housing 142, the mouthpiece 136 is wider than the tank housing 142, so as to define a lip 146 that overhangs the tank housing 142. This lip 146 acts as a stop feature when the consumable 104 is inserted into the main body 102 (i.e. by contact with an upper edge of the main body 102).

The tank 106, the passage 140 and the mouthpiece 136 are integrally formed with each other so as to form a single unitary component and may e.g. be formed by way of an injection moulding process. Such a component may be formed of a thermoplastic material such as polypropylene.

The mouthpiece 136 comprises a mouthpiece aperture 148 defining an outlet of the passage 140. The vaporiser 132 is fluidly connected to the mouthpiece aperture 148 and is located in a vaporising chamber 156 of the consumable 104. The vaporising chamber 156 is downstream of the inlet 134 of the consumable 104 and is fluidly connected to the mouthpiece aperture 148 (i.e. outlet) by the passage 140.

The vaporiser 132 comprises a porous wick 150 and a heater filament 152 coiled around the porous wick 150. The wick 150 extends transversely across the chamber vaporising 156 between sidewalls of the chamber 156 which form part of an inner sleeve 154 of an insert 158 that defines the lower end 111 of the consumable 104 that connects with the main body 102. The insert 158 is inserted into an open lower end of the tank 106 so as to seal against the tank housing 142.

In this way, the inner sleeve 154 projects into the tank 106 and seals with the passage 140 (around the passage wall 144) so as to separate the vaporising chamber 156 from the e-liquid in the tank 106. Ends of the wick 150 project through apertures in the inner sleeve 154 and into the tank 106 so as to be in contact with the e-liquid in the tank 106. In this way, e-liquid is transported along the wick 150 (e.g. by capillary action) to a central portion of the wick 150 that is exposed to airflow through the vaporising chamber 156. The transported e-liquid is heated by the heater filament 152 (when activated e.g. by detection of inhalation), which causes the e-liquid to be vaporised and to be entrained in air flowing past the wick 150. This vaporised liquid may cool to form an aerosol in the passage 140, which may then be inhaled by a user.

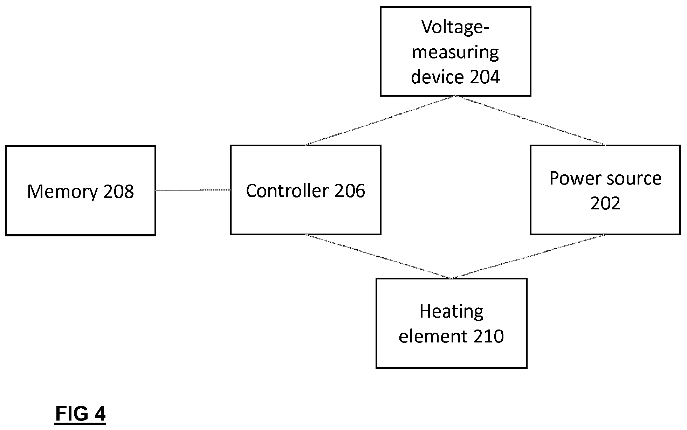

Fig. 4 is a schematic diagram of the components which are configured to perform the method of the first aspect of the present invention. The system 200 includes power source 202, voltage-measuring device 204, controller 206, memory 208, and heating element 210. In some embodiments, all of these components are present on the main body of a smoking substitute device, however in other embodiments, the power source 202, voltage-measuring device 204, controller 206 and memory 208 are present on the main body of the smoking substitute device, and the heating element 210 is present on a consumable. The power source 202 is connected to voltage-measuring device 204, which is configured to measure the power source voltage, e.g. the battery voltage. The voltage-measuring device 204 is configured to output the voltage measurement to the controller 206. The controller 206 then determines a power source voltage range within which the determined power source voltage falls. The controller 206 is then configured to adjust the duty cycle regime at which the smoking substitute system 200 operates, based on the determined power source voltage.

An example scheme of the present invention is as follows:

| Power source voltage (V) | Duty cycle |
|---|---|
| V < 4.00 | 100% |

(continued)

| Power source voltage (V) | Duty cycle |
|---|---|
| 4.00 ≤ V < 4.05 | 97.5% |
| 4.05 ≤ V < 4.10 | 95% |
| 4.10 ≤ V < 4.15 | 92.5% |
| 4.15 ≤ V < 4.20 | 90% |

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the words "have", "comprise", and "include", and variations such as "having", "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means, for example, +/- 10%.

The words "preferred" and "preferably" are used herein refer to embodiments of the invention that may provide certain benefits under some circumstances. It is to be appreciated, however, that other embodiments may also be preferred under the same or different circumstances. The recitation of one or more preferred embodiments therefore does not mean or imply that other embodiments are not useful, and is not intended to exclude other embodiments from the scope of the disclosure, or from the scope of the claims.

**Claims**

1. A method for controlling the power delivered to a heating element of a smoking substitute device, the method including the steps of:

   determining a power source voltage of a power source of the smoking substitute device, the power source electrically connected or electrically connectable to the heating element;
   determining whether the power source voltage falls within a first power source voltage range or a second power source voltage range, wherein all power source voltages in the second power source voltage range are greater than all power source voltages in the first power source voltage range; and
   varying a duty cycle regime based on a result of the determination.

2. A method according to claim 1, wherein:
   the electrical connection between the heating element and the power source is controlled or controllable by an electronic switch including a field-effect transistor.

3. A method according to claim 1 or claim 2, wherein:
   the step of varying the duty cycle based on the result of the determination is performed using pulse-width modulation, PWM.

4. A method according to any one of claims 1 to 3, wherein:
   a first predetermined power source voltage threshold is defined, and the step of determining whether the power source voltage falls with the first power source voltage range or the second power source voltage range may comprise comparing the determined power source voltage with the first predetermined power source voltage threshold, and the step of varying the duty cycle regime may be based on a result of that comparison.

5. A method according to any one of claims 1 to 4, wherein:
   the step of varying a duty cycle may comprise switching between a first duty cycle regime and a second duty cycle regime.

6. A method according to claim 5, wherein:

   the step of varying the duty cycle regime comprises:

      if the determined power source voltage is in the first power source voltage range, operating the smoking substitute device at a first duty cycle; and
      if the determined power source voltage is in the second power source voltage range, operating the smoking substitute device at a second duty cycle,

   wherein the first duty cycle is higher than the second duty cycle.

7. A method according to any one of claims 1 to 5, wherein:
   one or both of the first duty cycle regime and the second duty cycle regime is a variable duty cycle.

8. A method according to claim 7, wherein:
   the first duty cycle and/or the second duty cycle is a duty cycle which varies as a function of a parameter.

9. A method according to claim 8, wherein:
   the first duty cycle and/or the second duty cycle is a duty cycle which varies as a function of the determined power source voltage.

10. A method according to any one of claims 1 to 9, wherein:
    the first duty cycle regime is a duty cycle of 100%.

11. A method according to any one of claims 1 to 10, comprising:

    determining whether the determined power source voltage falls within the first power source voltage range, the second power source voltage range, or a third power source voltage range, wherein all power source voltages within the third power source voltage range are greater than all power source voltages which fall within the second power source range; and wherein varying a duty cycle regime comprises:

       if the determined power source voltage falls within the first power source voltage range, operating the smoking substitute device in a first duty cycle regime;
       if the determined power source voltage falls within the second power source voltage range, operating the smoking substitute device in a second duty cycle regime; and
       if the determined power source voltage falls within the third power source voltage range, operating the smoking substitute device in a third duty cycle regime,

wherein the first duty cycle regime is higher than the second duty cycle regime, and the second duty cycle regime is higher than the second duty cycle regime.

12. A method according to claim 11, wherein:

a first predetermined power source voltage threshold and a second predetermined power source voltage threshold may be defined, wherein the first predetermined power source voltage threshold is the power source voltage on the boundary of the first power source voltage range and the second power source voltage range, and the second predetermined power source voltage threshold is the power source voltage on the boundary of the second power source voltage range and the third power source voltage range;
the step of determining in which power source voltage range falls includes:

comparing the determined power source voltage with the first predetermined power source voltage threshold; and
comparing the determined power source voltage with the second predetermined power source voltage threshold; and

the step of varying a duty cycle regime based on the determination includes:

if the determined power source voltage is less than the first predetermined power source voltage threshold, operating the smoking substitute device in the first duty cycle regime;
if the determined power source voltage is greater than or equal to the first predetermined power source voltage regime and less than the second predetermined power source voltage threshold, operating the smoking substitute device in the second duty cycle regime; and
if the determined power source voltage is greater than or equal to the second predetermined power source voltage threshold, operating the smoking substitute device in the third duty cycle regime.

13. A method according to any one of claims 1 to 12, wherein:

a plurality of power source voltage ranges may be defined, where all power source voltages in each successive power source voltage range are greater than power source voltages in all previous power source voltage ranges;
each power source voltage range has a respective associated duty cycle regime, where each successive duty cycle regime is lower than the previous duty cycle
the method includes:

determining in which power source voltage range the determined power source voltage falls; and
varying the duty cycle regime may comprise operating the smoking substitute device in the duty cycle regime which is associated with the determined power source voltage range.

14. A smoking substitute device including:

a power source having an associated power source voltage; and
control circuitry configured to perform the method of any one of claims 1 to 13.

**FIG 1A**

**FIG 1B**

**FIG 1C**

102

Main body

| Power source |
|---|

118

| Controller | Memory |
|---|---|

120 | | 122

| Wireless interface | Additional components |
|---|---|

124 | | 128

| Electrical interface |
|---|

126

**FIG 2A**

104

130

Consumable

| Electrical interface |
|---|

| Tank | Vaporiser |
|---|---|

106 | | 132

| Air inlet(s) | Additional components |
|---|---|

134 | | 138

| Mouthpiece |
|---|

136

**FIG 2B**

**FIG 3**

**FIG 4**

Europäisches
Patentamt

European
Patent Office

Office européen
des brevets

# EUROPEAN SEARCH REPORT

Application Number

EP 19 19 4600

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/247597 A1 (YAMADA MANABU [JP] ET AL) 15 August 2019 (2019-08-15)<br>* figure 1a *<br>* paragraph [0002] *<br>* paragraph [0120] *<br>* paragraph [0121] *<br>* paragraph [0126] * | 1-14 | INV.<br>A24F40/50 |
| X | EP 0 973 419 A1 (PHILIP MORRIS PROD [US]) 26 January 2000 (2000-01-26)<br>* abstract; claim 6; figure 8 *<br>* paragraph [0001] *<br>* paragraph [0008] *<br>* paragraph [0038] *<br>* paragraph [0081] - paragraph [0083] * | 1-14 | |
| X | US 2018/325182 A1 (ZITZKE ROLAND [DE] ET AL) 15 November 2018 (2018-11-15)<br>* paragraph [0013] - paragraph [0015] *<br>* paragraph [0022] *<br>* paragraph [0042] *<br>* paragraph [0006] * | 1-14 | |

TECHNICAL FIELDS
SEARCHED (IPC)

A24F

The present search report has been drawn up for all claims

| Place of search | Date of completion of the search | Examiner |
|---|---|---|
| Munich | 4 March 2020 | Schnitzhofer, Markus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 19 19 4600

This annex lists the patent family members relating to the patent documents cited in the above-mentioned European search report.
The members are as contained in the European Patent Office EDP file on
The European Patent Office is in no way liable for these particulars which are merely given for the purpose of information.

04-03-2020

| Patent document cited in search report | | Publication date | Patent family member(s) | | Publication date |
|---|---|---|---|---|---|
| US 2019247597 | A1 | 15-08-2019 | CA | 3037654 A1 | 02-08-2018 |
| | | | CN | 110446435 A | 12-11-2019 |
| | | | DE | 212017000292 U1 | 17-09-2019 |
| | | | EA | 201991024 A1 | 30-09-2019 |
| | | | JP | 6462965 B2 | 30-01-2019 |
| | | | JP | WO2018138749 A1 | 07-02-2019 |
| | | | TW | 201826953 A | 01-08-2018 |
| | | | US | 2019247597 A1 | 15-08-2019 |
| | | | US | 2019247598 A1 | 15-08-2019 |
| | | | WO | 2018138749 A1 | 02-08-2018 |
| EP 0973419 | A1 | 26-01-2000 | AT | 284628 T | 15-01-2005 |
| | | | AU | 743847 B2 | 07-02-2002 |
| | | | CA | 2268657 A1 | 30-04-1998 |
| | | | DE | 69731980 D1 | 20-01-2005 |
| | | | DE | 69731980 T2 | 22-12-2005 |
| | | | EP | 0973419 A1 | 26-01-2000 |
| | | | ES | 2235229 T3 | 01-07-2005 |
| | | | HK | 1022080 A1 | 13-05-2005 |
| | | | JP | 3976345 B2 | 19-09-2007 |
| | | | JP | 2001502542 A | 27-02-2001 |
| | | | MX | PA99003671 A | 26-05-2005 |
| | | | PT | 973419 E | 29-04-2005 |
| | | | US | 6040560 A | 21-03-2000 |
| | | | WO | 9817131 A1 | 30-04-1998 |
| US 2018325182 | A1 | 15-11-2018 | CN | 105764366 A | 13-07-2016 |
| | | | EP | 2856893 A1 | 08-04-2015 |
| | | | GB | 2518937 A | 08-04-2015 |
| | | | TW | 201528979 A | 01-08-2015 |
| | | | US | 2016213066 A1 | 28-07-2016 |
| | | | US | 2018325182 A1 | 15-11-2018 |
| | | | WO | 2015049046 A2 | 09-04-2015 |

EPO FORM P0459

For more details about this annex : see Official Journal of the European Patent Office, No. 12/82